# EUROPÄISCHE PATENTSCHRIFT

(11) **EP 0 662 161 B1**
(45) Veröffentlichungstag und Bekanntmachung des Hinweises auf die Patenterteilung: **26.02.1997**
(21) Anmeldenummer: 93917541.0
(22) Anmeldetag: 11.08.1993
(51) Int. Cl.: C23C 14/00, C23C 14/02, B24B 39/02, B23P 9/00, B21C 37/30

(54) **WERKZEUG ZUR BEHANDLUNG VON OBERFLÄCHEN VON BAUTEILEN UND TRÄGERWERKSTOFF FÜR DIESES WERKZEUG**
TOOL FOR WORKING THE SURFACES OF COMPONENTS, AND A SUBSTRATE MATERIAL FOR SUCH A TOOL
OUTIL POUR LE TRAITEMENT DE SURFACES D'ELEMENTS DE CONSTRUCTION ET SUBSTRAT POUR LEDIT OUTIL

(30) Priorität: 28.09.1992 DE 4232429
(43) Veröffentlichungstag der Anmeldung: 12.07.1995
(73) Patentinhaber: ROBERT BOSCH GMBH, 70442 Stuttgart (DE)
(72) Erfinder: FINKBEINER, Ludwig, D-74399 Walheim (DE)
(86) Internationale Anmeldenummer: DE9300717
(87) Internationale Veröffentlichungsnummer: WO9408066

(56) Entgegenhaltungen:
- EP-A- 0 515 868
- DE-A- 2 431 448
- DE-A- 3 809 139

## Beschreibung

### Stand der Technik

Die Erfindung bezieht sich auf ein Werkzeug zur Behandlung von Oberflächen von Bauteilen und einen Trägerwerkstoff für dieses Werkzeug. Bisher werden zur Feinbearbeitung Oberflächen mit Hilfe von Honwerkzeugen behandelt. Honwerkzeuge sind hierbei relativ kompliziert aufgebaut. Sie weisen an der Oberfläche eine mit Schleifmitteln, insbesondere Edelkorund oder Siliciumkarbit versehene Arbeitsschicht auf. Im Inneren der sogenannten Honsteine sind Spreizkegel vorhanden, mit denen die notwendige Anpreßkraft über die Honsteine an die Bohrungswandung gedrückt wird.

Aus der nachveröffentlichten EP-A 0 515 868 ist ein Werkzeug für Feinstbearbeitung bekannt. Der Grundkörper für dieses Werkzeug besteht aus hochlegiertem Drucksinterwerkstoff, worauf im Arbeitsbereich zwecks Haftung eine dünne Nickelschicht aufgebracht wird und darauf eine Hartschicht aus Titan sich befindet. Das Werkzeug bzw. das Verfahren wird nun durch Einzelmaßnahmen verfeinert und verbessert.

### Vorteile der Erfindung

Das erfindungsgemäße Werkzeug und insbesondere der Trägerwerkstoff hierzu hat einen sehr homogenen, sehr feinkörnigen und relativ einfach legierbaren Aufbau. Er ist als Träger für eine metallische Beschichtung, die wiederum eine Nichtmetallische-Hartschicht teilkohäsiv trägt, verwendbar. In einfacher Weise kann der Werkstoff durch spanabhebende Verfahren vorbereitet werden, um ein Halbzeug mit einer geeigneten einstellbaren Rauigkeit zu erreichen. Die Oberfläche ist frei von Werkzeugverschmutzungen. Die aufgebrachte Nichtmetallische-Hartschicht stellt eine Verschleißschicht mit hoher Lebensdauer dar. Da sie keine Poren, Risse oder weitere Fehlstellen aufweist, ist sie frei von Rost oder Korrosion.

Die Herstellung des Werkzeugs ist relativ billig, insbesondere einfacher und preisgünstiger als die bisher verwendeten Honwerkzeuge. Das Werkzeug kann nahezu spielfrei hergestellt werden. Das Ergebnis ist ein kleines Toleranzband. Selbst lange und relativ dünne Werkzeuge können hergestellt werden. Die hochelastische Bindung der Metallschicht mit Hilfe einer Aktivierungsschicht am Trägerwerkzeug verhindert Mikrorisse durch Eigenspannungen und durch im Einsatz unregelmäßig auftretende Fremdspannungen.

Durch die in den Unteransprüchen aufgeführten Merkmale und Maßnahmen sind vorteilhafte Weiterbildungen des in den unabhängigen Ansprüchen angegebenen Werkzeugs oder Trägerwerkstoffs möglich.

### Zeichnung

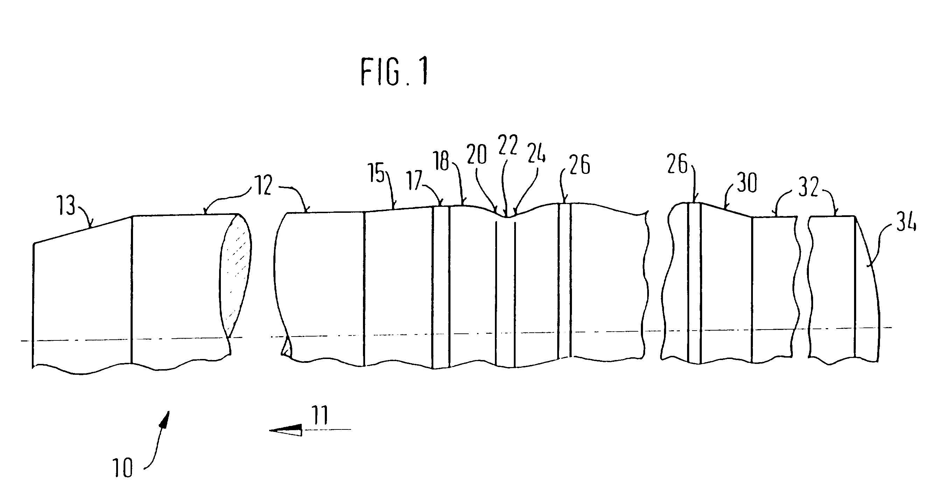

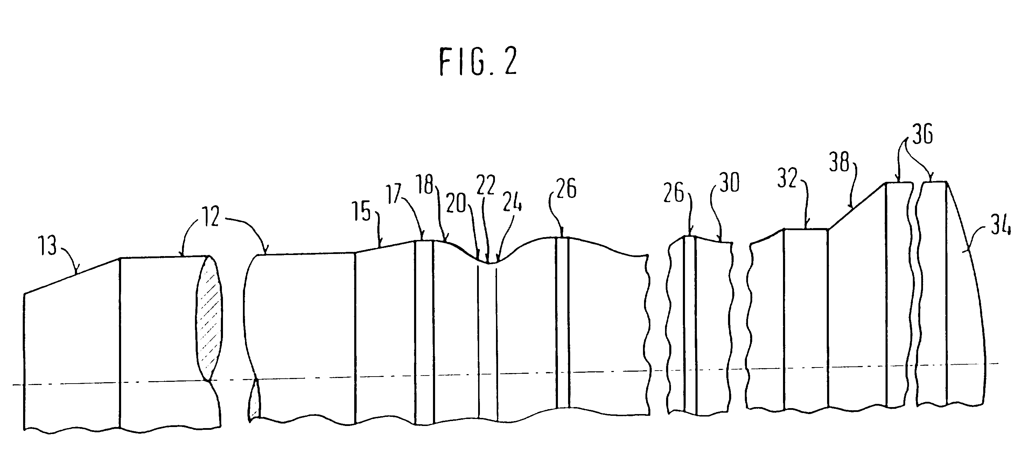

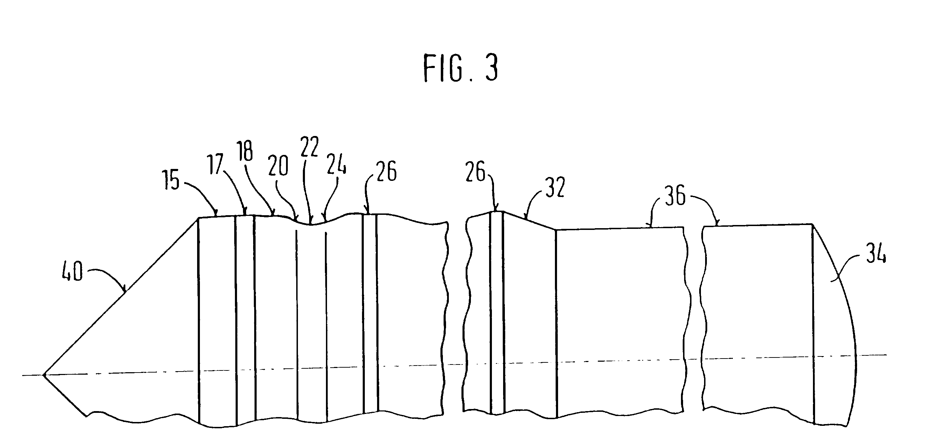

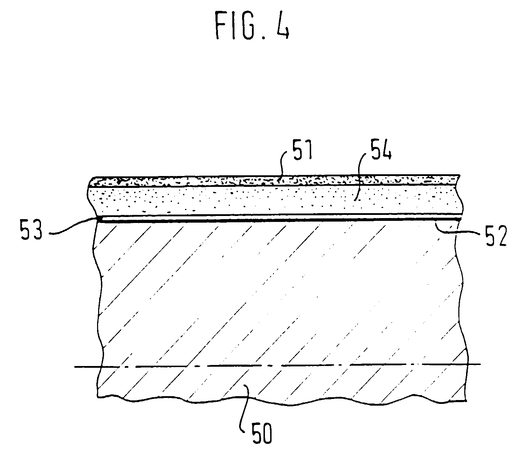

Ausführungsbeispiele der Erfindung sind in der nachfolgenden Zeichnung dargestellt und in der nachfolgenden Beschreibung näher erläutert. Es zeigen die Figur 1 einen Längsschnitt durch das erfindungsgemäße Werkzeug in schematischer Darstellung, wobei die einzelnen Bereiche zur Verdeutlichung nicht maßstabsgetreu dargestellt sind. In den Figuren 2 und 3 sind Abwandlungen nach dem Ausführungsbeispiel nach Figur 1 dargestellt, und in der Figur 4 ist ein schichtartiger Aufbau der Hartschicht auf den Crundwerkstoff des Werkzeuges gezeigt.

### Beschreibung der Ausführungsbeispiele

In der Figur 1 ist mit 10 ein Werkzeug bezeichnet, das zur gleichzeitigen Glättung und Härtung von Oberflächen geeignet ist. In Arbeitsrichtung gesehen, die in der Figur 1 mit dem Pfeil 11 gekennzeichnet ist, hat das Werkzeug 10 am Anfang einen Zentrierbereich 12. Dieser Zentrierbereich 12 weist einen konisch verlaufenden Einführbereich 13 auf, der etwa eine Schräge von ca. 7° aufweist. Der Einführbereich 13 dient dazu, um das Werkzeug ohne Beschädigung, z.B. in eine Bohrung, einzuführen. Zur Erläuterung ist im folgenden dann immer auf eine Bohrung eingegangen. Der Übergang vom Einführbereich 13 in den Zentrierbereich 12 weist einen Feinstradius auf. Dies ist notwendig, um eine Beschädigung der zu bearbeitenden Oberfläche zu verhindern. Der Zentrierbereich 12 selbst ist zylindrisch ausgebildet. Wichtig ist aber, daß die Achse des Werkzeugs 10 und die Achse der Bohrung zusammenfallen, so daß das Werkzeug 10 nicht in der Bohrung verkantet.

An den Zentrierbereich 12 schließt sich ein Einlaufbereich 15 an, der eine Schräge aufweist. Die Steigung dieser Schräge liegt zwischen 0,7° und 2,3°. Sie ist abhängig vom Werkstoff des Werkzeugs als auch vom Werkstoff des zu bearbeitenden Bauteils, d.h. hier z.B. eines Ventils, in dem die Bohrung ausgebildet ist. Die Werte der Steigung sind zur Zeit noch empirisch zu ermitteln. Dieser Einlaufbereich 15 dient dazu, um ein undefiniertes Abschaben durch den sich anschließenden Arbeitsbereich 17 am Beginn der Bohrung zu verhindern. Vom Einlaufbereich 15 führt ein Tangentialbereich 18 zum Arbeitsbereich 17. Der Verlauf des Tangentialbereichs 18 entspricht nahezu einem großen Radius, so daß er einer Tangente entsprechen würde. Dieser Tangentialbereich 18 ist notwendig, um einen kantigen Übergang vom Einlaufbereich 15 auf den Arbeitsbereich 17 zu vermeiden. Durch die radiusartige Ausbildung des Tangentialbereichs 18 wird bereits eine Verdichtung des Materials des zu bearbeitenden Bauteils bewirkt. Im Unterschied zu einem, wie oben ausgeführt, nicht erwünschten kantigen Übergang, wird durch den Radius des Tangentialbereichs 18 keine Verschiebung des Materials des Werkstoffs im Mikrobereich in Bewegungsrichtung 11 des Werkzeugs 10 bewirkt, sondern das Material wird weitgehend radial nach außen, d.h. senkrecht oder unter 90° zur Bewegungsrichtung 11 verschoben. Der Radius des Tangentialbereichs 18 ist abhängig vom Material des Bauteils und auch abhängig vom Verhältnis zwischen der Länge und dem Durchmesser des Werkzeugs 10.

Der sich nun anschließende, eigentliche Arbeitsbereich 17 besteht aus einem zylindrischen Bereich, wobei der Durchmesser bis etwa 0,2% größer als der gewünschte Durchmesser der zu bearbeitenden Bohrung ist. Dieses Aufmaß ist abhängig vom Material des Bauteils und der Länge der Bohrung. Die Breite dieses Arbeitsbereichs 17 am Werkzeug 10 entspricht in etwa 0,4% des bearbeiteten Durchmessers der Bohrung. An den Arbeitsbereich 17 schließt sich ein Erholungsbereich 20 an, der kurvenförmig ausgebildet ist. Er dient zur Erholung für das vom Arbeitsbereich 17 bearbeitete Material des Bauteils. Die Erholungsphase findet im Mikrobereich der Oberfläche der Bohrung des Bauteils statt. Das Material des Bauteils kann sich im Erholungsbereich 20 wieder geringfügig verteilen.

Nach dem Erholungsbereich 20 ist eine Sammelmulde 22 für Fremdkörper vorhanden, die sich durch die vorausgegangene mechanische Vorbehandlung in der Bohrung befinden. Hierbei kann es sich z.B. um Schleifkörner handeln oder um sonstige Verschmutzungen oder um verbrauchte Bestandteile der Flüssigkeit, die, wie weiter unten noch erwähnt wird, zur Glättung der Oberfläche der Bohrung mit Hilfe des Werkzeugs 10 verwendet wird. Die Sammelmulde 22 ist radiusförmig ausgebildet, wobei der Radius abhängig ist vom Durchmesser und der Länge des Werkzeugs. Ein kontinuierlicher Übergang vom Erholungsbereich 20 in die Sammelmulde 22, wie bei einer zusammengesetzten Kurve bei mathematischer Betrachtung, ist für eine beschädigungsfreie Rückbewegung des Werkzeugs aus der Bohrung wichtig. Der sich anschließende Bereich 24 entspricht in seiner Form, Wirkung und Aufgabe dem Erholungsbereich 20. Würde man durch das Minimum, d.h. durch den tiefsten Punkt der Sammelmulde 22 eine gedachte Spiegelachse legen, so würde der Übergang von der Sammelmulde 22 in den Bereich 24 und der Bereich 24 selbst eine spiegelbildliche Wiederholung des Erholungsbereichs 20 und des Übergangs vom Erholungsbereich 20 in die Sammelmulde 22 darstellen. Dies bedeutet auch, daß der Bereich 22 kontinuierlich in einen zweiten Arbeitsbereich 26 übergeht, und zwar so, wie der Arbeitsbereich 17 in den Erholungsbereich 20 übergeht. Dieser Arbeitsbereich 26 hat nur noch ca. 60% der Länge des Arbeitsbereichs 17. Der Durchmesser entspricht aber genau dem Durchmesser des Arbeitsbereichs 17. Bis auf die Länge der Arbeitsbereiche 26 und 17 stellen die Bereiche Übergang von der Sammelmulde 22 in den Bereich 24, der Bereich 24 selbst, der Arbeitsbereich 26 eine spiegelbildliche Wiederholung der Bereiche 17, 20, 22 dar. Der Arbeitsbereich 26 und die zwischen den Arbeitsbereichen 17 und 26 liegenden Bereiche wiederholen sich nun identisch so oft, bis die Länge des zu bearbeitenden Teils erreicht ist. Die sich wiederholenden Arbeitsbereiche 26 weisen alle 60% der Länge des ersten Arbeitsbereichs 17 auf. An den letzten Arbeitsbereich 26 schließt sich ein Auslaufbereich 30 an, dessen Steigung einen geringfügig größeren Steigungswinkel als der Einführbereich 15 aufweist. Der Steigungswinkel liegt zwischen 3° und 7°. Er dient wieder als Ausdehnungsbereich für den soeben bearbeiteten Werkstoff des Bauteils.

Der Übergang vom Auslaufbereich 30 in den Auslaufzylinder 32 ist radiusförmig, um so eine Bruchgefahr für das Werkzeug zu vermeiden.

Die Länge des Auslaufzylinders 32 entspricht etwa 60% des Zentrierbereiches 12. Der Durchmesser des Auslaufzylinders 32 ist etwa 0,5% bis 1% geringer als der Durchmesser des Arbeitsbereiches 17 oder 26. Dies bedeutet auch, daß der Durchmesser des Auslaufzylinders 32 kleiner ist als der Durchmesser des Zentrierbereichs 12. Im Einzelfall kann er aber auch gleich groß sein.

Den Abschluß des Werkzeugs 10 bildet eine Kalotte 34, die zur Krafteinleitung und Kraftübertragung der Vorschubbewegung für das Werkzeug 10 in Richtung des Pfeils 11 dient. Die Kalotte 34 ist dabei so auszubilden, daß eine punktförmige Krafteinleitung, z.B. mit Hilfe einer automatischen Presse möglich ist. Der Radius ist empirisch ermittelt und abhängig von der Länge und vom Durchmesser des Werkzeugs 10. Unter mathematischer Betrachtungsweise hat die Kalotte 34 bei kleinem Durchmesser des Werkzeuges 10 die Form eines Korbbogens, was bedeutet, daß die Seitenflächen der Kalotte 34 steiler verlaufen als bei einer radiusförmigen Ausbildung. Dies ist insbesondere bei Werkzeugen mit größerer Länge und kleinerem Durchmesser notwendig. Ferner wäre die Kalotte 34 spiegelbildlich zu einer durch die Spitze der Kalotte 34 verlaufenden gedachten Spiegelachse auszubilden.

Die oben beschriebenen Bereiche des Werkzeugs stellen die wesentlichen Abschnitte dar, die unabhängig von der Verwendung des Werkzeugs immer vorhanden sind. Wird nun das Werkzeug dazu verwendet, eine durchgehende Bohrung zu bearbeiten, so ist der Zentrierbereich 12, wie oben beschrieben, direkt am Werkzeug ausgebildet. Alternativ könnte ein Zentrierberich am zu bearbeitenden Bauteil angebracht sein. An dem Zentrierbereich 12 schließen sich noch der oder die Arbeitsteile des Werkzeugs an. Er besteht aus dem Arbeitsbereich 17 bis zum Arbeitsbereich 26, wobei sich dieser Arbeitsteil mehrfach wiederholt. Wie bereits oben erwähnt, ist dann nach der ersten Wiederholung der Arbeitsbereich 26 immer gleich lang, hat aber jeweils nur 60% der Länge des ersten Arbeitsbereichs 17, der sich an den Einlaufbereich 15 anschließt. Der Arbeitsteil besteht nun aus mehreren Stufen, wobei die Arbeitsbereiche 17 und 26 der einzelnen Stufen jeweils einen größeren Durchmesser aufweisen. Hierbei nimmt der Durchmesser von Stufe zu Stufe nicht linear zu, sondern die Zunahme der Durchmesser der Arbeitsbereiche 17, 26 bzw. 17a, 26a ist über die gesamte Länge des Werkzeugs kurvenförmig und hat z.B. die Form einer logarithmischen oder einer potentiell verlaufenden Kurve. Der genaue Verlauf für das Werkzeug ist empirisch ermittelt worden. Die letzte Stufe, d.h. der Arbeitsbereich 26 ist dann dem Durchmesser der bearbeiteten Bohrung mit dem notwendigen Gesamtaufmaß (das Aufmaß nimmt ebenfalls pro Stufe zu) angepaßt. An diesen Arbeitsbereich 26 schließt sich der Auslaufbereich 30, der Auslaufzylinder 32 und die Kalotte 34 an.

In einer Variation des Werkzeugs kann dieses auch zur Bearbeitung einer Sacklochbohrung verwendet werden. Hierbei ist es notwendig, das Werkzeug wieder aus der Sacklochbohrung herauszuziehen, was einen Bereich erfordert, der zum Angriff eines geeigneten Werkzeugs geeignet ist. Es ist hierzu zwischen dem Auslaufzylinder 32 und der Kalotte 34 ein Mitnahmebereich 36 angeordnet. Dieser Mitnahmebereich 36 ist z.B. als Zweiflachkant oder als Vierflachkant ausgebildet. Für ein sicheres Herausziehen des Werkzeugs 10 ist die Oberfläche des Mitnahmebereichs 36 mit einer bestimmten Rauigkeit auszuführen.

Bei einer anderen Variation können mit Hilfe des Werkzeugs auch Sitze und Schultern in der Bohrung ausgebildet werden. Hierzu hat das Werkzeug nach dem Arbeitsbereich 26 einen Sitz 38, der dem Maß des gewünschten Sitzes in der Bohrung entspricht. Die Schräge des Sitzes 38 ist, abhängig vom Werkstoff des Bauteils um etwa 0,5% größer als die Schräge des zu schaffenden Sitzes (dies ist notwendig wegen dem Zurückfedern des Werkstoffs und des Bauteils). An diesem Sitz 38 würde sich dann der Auslaufzylinder 32 anschließen.

Selbstverständlich wäre es auch denkbar, um den Sitz von Einspritzventilen zu bilden, den Sitz vor dem Einführbereich 13 und vor dem Zentrierbereich 12 auszubilden. Beide Bereiche 13 und 12 werden bei dem vorgeschobenen Sitz 40 in der Länge sehr klein oder können, wie in Figur 3 gezeigt, entfallen. Es würden sich nun die Arbeitsbereiche 17 und die nachfolgenden, wie oben beschriebenen Bereiche anschließen. Ferner könnte auch ein gestufter Arbeitsbereich mit einem zur Ausbildung eines Sitzes geeigneten Sitz verwendet werden. Die oben beschriebenen Arbeitsbereiche und gegebenenfalls Sitze können in beliebiger Weise miteinander an einem Werkzeug kombiniert werden.

Um mit dem oben beschriebenen Werkzeug eine Oberfläche härten und glätten zu können, muß das Werkzeug 10 aus einem bestimmten Material hergestellt sein und eine mit einem besonderen Verfahren aufgebrachte Randschicht aufweisen. Der Grundkörper 50 des Werkzeugs 10 muß aus einem Metall mit einem homogenen, feinkörnigen Gefüge bestehen. Will man ein dünnes Werkzeug etwa mit einem Durchmesser von 2 bis 12 mm herstellen, so verwendet man hierzu Hochdrucksinterhalbzeuge, d.h. einen Träger, der im Hochdrucksinterverfahren hergestellt wurde. Für dickere Werkzeuge kann Hochleistungsschnellschnittstahl (HSS) verwendet werden. In allen Fällen wird aber ein Werkzeug hergestellt, dessen Durchmesser etwa um 40% größer ist als der für den späteren Arbeitsbereich 17, 26 gewünschte Durchmesser. In diesen über den gewünschten Durchmesser hinausgehenden Bereich befinden sich Verschmutzungen und Entkohlungen, die bei der Herstellung des Halbzeugs, sowohl für ein dickes oder für ein dünnes Werkzeug, entstehen. Dieser 40%ige Überhang des Durchmessers wird mechanisch, d.h. z.B. durch Fräsen entfernt. Die dann entstehende Oberfläche sollte aber möglichst glatt sein. Nach dem Abfräsen erhält man einen im Zentrum relativ homogenen Träger- bzw. Grundwerkstoff 50. Ferner wird durch diese mechanische Bearbeitung der verbleibende Werkstoff für das Werkzeug verdichtet. Dies bedeutet, daß die Körner noch besser miteinander verschmelzen, so daß ein noch dichteres Gefüge entsteht. Dieses so hergestellte Halbzeug für das Werkzeug dient als Ausgangsmaterial für das Erzeugen bzw. Aufbringen einer Nichtmetallischen-Hartschicht 51. Diese Hartschicht ist zusammen mit der oben beschriebenen geometrischen Form des Werkzeugs 10 wesentlich für die Qualität der Härte und der Glätte der behandelten Oberfläche.

Angestrebt ist am Ende der Bearbeitungsphasen eine Nichtmetallische Hartschicht auf der Außenwand, d.h. auf der die sogenannte Arbeitsfläche des Werkzeugs bildende Wand. Diese Nichtmetallische-Hartschicht 51 ist aber auf einem metallischen Trägerwerkstoff 50, wie er oben beschrieben ist, aufzubringen. Ein entsprechender Aufbau des Werkzeugs 10 ist in der Figur 4 dargestellt. Hier ist mit 50 der Trägerwerkstoff bezeichnet, der mit einem homogenen, feinkörnigen Gefüge in der oben erläuterten Weise hergestellt ist. Wichtig ist hierbei, daß die Oberfläche des Trägerwerkstoffs 50 möglichst glatt ist und über die gesamte Länge die Maßhaltigkeit erfüllt. Auf den Trägerwerkstoff 50 ist eine dünne, ca. 0,2 bis 0,3 µm dicke Aktivierungsschicht 52 aufgebracht. Diese Aktivierungsschicht 52 besteht z.B. aus Platin, Paladium, Zinn, Nickel, Silber oder Gold. Natürlich sind auch Stoffverbindungen von diesen Stoffen untereinander möglich. Diese Aktivierungsschicht 52 liegt netzartig auf der gesamten Außenfläche des Trägerwerkstoffs 50 auf, was bedeutet, daß die Aktivierungsschicht nicht schließen kann, also keine völlig geschlossene Oberfläche auf dem Trägerwerkstoff 50 bilden soll. Diese Aktivierungsschicht 52 wird elektrolytisch-chemisch aufgebracht. Dies bedeutet, daß gegenüber einem elektrolytischen Verfahren (physikalisches Verfahren) der Elektrolyt eine zusätzliche Reinigungsaufgabe mit erfüllt.

Die Aktivierungsschicht 52 ist kohäsiv und stellt einen Weichwerkstoff dar. Sie ist nun kohäsiv mit dem Werkstoff des Trägers 50 verbunden und soll ebenfalls kohäsiv mit der nachfolgenden Reinmetallschicht 44 verbunden werden. Hierbei diffundieren die Ionen der Aktivierungsschicht 52 in den Trägerwerkstoff 50 ein. Man erhält dadurch eine elastische Zwischenschicht, die wie ein Netz die Aktivierungsschicht 52 mit dem Trägerwerkstoff 50 verbindet. Anschließend wird auf der Aktivierungsschicht 52 eine Reinmetallschicht 53, z.B. von Titan, Chrom, Bor oder Wolfram aufgebracht. Diese Reinmetallschicht wird durch Ionenaustausch und Sputtern (PVD-Verfahren, d.h. physikal vapour deposition) aufgebracht. Gleichzeitig wird im Lichtbogen die entstehende Schicht durch Schmelzen verbunden. Dies geschieht so lange, bis eine Mindestschicht von 0,3 bis 0,5 µm auf der Aktivierungsschicht 52 vorhanden ist. Diese Reinmetallschicht 53 ist somit kohäsiv mit dem Trägerwerkstoff 50 über die Aktivierungsschicht 52 verbunden und ist auch teilkohäsiv mit der im folgenden erläuterten sich aufbauenden Nichtmetallischen-Hartschicht 51 verbunden.

Hat die Reinmetallschicht 53 ihre Mindestschichtdicke erreicht, werden in definierter Weise Kohlenstoff- und/oder Stickstoffionen dazugegeben, so daß sich über eine Übergangsschicht 54 die Nichtmetallische-Hartschicht 51 aufbauen kann. Die Kohlenstoff- bzw. Stickstoffionen werden im sogenannten PVD-Verfahren (Physical Vapour Deposition) im Vakuum z.B. bei mindestens 10⁻³ bar oder Hochvakuum durchgeführt. Hierbei wird der Anteil der zugeführten Komponenten Stickstoff und Kohlenstoff radial nach außen gesehen, d.h. zur Nichtmetallischen-Hartschicht 51 hin immer größer. Der Übergangsbereich 54 schließt dann mit der homogenen Nichtmetallischen-Hartschicht 51 ab, die eine Dichtheit von ca. 95% bis 98% besitzt. Diese Nichtmetallische-Hartschicht 51 besteht dann aus einer Metallkohlenstoff-Stickstoffverbindung bzw. Metallkohlenstoffverbindung bzw. Metallstickstoffverbindung (Nitridlegierung). Am Beispiel Titan könnte die Hartschicht 51 aus TiN oder Ti(CN) bestehen.

Um mit dem oben beschriebenen Werkzeug 10 Oberflächen bearbeiten zu können, muß eine im folgenden beschriebene Ionen-Schmier-Flüssigkeit verwendet werden. Diese Flüssigkeit hat die Aufgaben Schmierung, Kühlung und Legierung der zu behandelnden Oberfläche. Während bisher für jeden dieser drei Vorgänge eine eigene, auf die jeweilige Aufgabe abgestimmte Flüssigkeit verwendet wurde, werden die drei Aufgaben nun nur noch von einer Flüssigkeit erfüllt. Aufgrund ihrer Zusammensetzung und ihrer Aufgabe wird die Flüssigkeit als Ionen-Schmier-Flüssigkeit bezeichnet. Diese Ionen-Schmier-Flüssigkeit hat eine Trägerflüssigkeit, die überwiegend aus organischen, säurearmen Ölen, wie z.B. Rappsöl besteht. Der restliche Bestandteil ist ein synthetisches Mineralöl, z.B. saurearmes chlorfreies Öl. Aufgrund der Kombination der beiden obengenannten Bestandteile wird die Viskosität der Ionen-Schmier-Flüssigkeit auf dünnflüssig, d.h. in einem Bereich von 9 bis 12 Ctst (Centistock) eingestellt. Die genaue Zusammensetzung ist abhängig von dem Werkstoff des zu bearbeitenden Werkstücks. Das heißt, daß statt der organischen Öle auch anorganische Öle verwendet werden können. In diese so vorbereitete Ionen-Schmier-Flüssigkeit wird nun mindestens 15 Volumenprozent Feinruß und mindestens 17 Volumenprozent Feingraphit eingebracht. Anschließend wird dieses Gemisch gefiltert (Korngröße maximal 0,3 µm), um eine möglichst dünnflüssige Ionen-Schmier-Flüssigkeit beizubehalten. Ferner muß eine feine und gleichmäßige Verteilung der beiden obengenannten Bestandteile, Feinruß und Feingraphit gewährleistet sein.

Im folgenden wird nun die Ionen-Schmier-Flüssigkeit auf das zu bearbeitende Werkstück und somit auf seine Legierungsaufgabe abgestimmt. Dies bedeutet, daß verschiedene Metall-Ionen, die im Werkstoff des zu bearbeitenden Werkstücks gut legierbar sind, wie z.B. Zinn (Sn), Gold (Au), Silber (Ag), Paladium (Pl), Nickel (Ni) zugegeben werden. Die so hergestellte Flüssigkeit wird gerührt und anschließend in geringen Mengen auf das Werkzeug 10 aufgetragen. Hierbei kann bereits ein Tropfen der Ionen-Schmier-Flüssigkeit ausreichen. Mit Hilfe des oben, sowohl bezüglich Geometrie als auch Zusammensetzung beschriebenen Werkzeugs 10 und der Ionen-Schmier-Flüssigkeit können nun die Oberflächen mit dem nachfolgenden Verfahren bearbeitet werden. Auf das Werkzeug 10 wird eine geringe Menge der Ionen-Schmier-Flüssigkeit aufgegeben. Anschließend wird das Werkzeug 10 in die Bohrung mit dem Einführbereich 13 und den Zentrierbereich 12 eingeführt. Das Werkzeug 10 wird hierbei mit einer äußerst guten Zentrierung in die Bohrung mit Hilfe einer automatischen Presse durch die Bohrung hindurchgeschoben. Hierbei ist eine bestimmte Mindestgeschwindigkeit notwendig, um ein Erwärmen in der Oberflächenstruktur der Bohrung zu erreichen. Diese Erwärmung ist wegen der Hartschicht 51 notwendig. Harte Werkstoffe würden im kalten Zustand beim Durchschieben reißen. Hingegen bei Erwärmung wird beim Durchschieben ein Werkstoffausgleich, d.h. ein Auffüllen der Bearbeitungsrillen erreicht. Aufgrund der Ionen-Schmier-Flüssigkeit entsteht wenig Reibung, wenn die Hartschicht 51 des Werkzeugs 10 über ungleiche Stellen der Bohrung hinweggeht. Die dabei frei werdenden Ionen werden in den Werkstoff des Bauteils eingebunden. Hierbei wird durch die Ionen-Schmier-Flüssigkeit eine kohäsive Einbindung erreicht, damit die Bestandteile der Bauteil-Oberfläche "nicht mehr herausfallen" können.

Bei der Variante mit dem zu bildenden Sitz wird das Werkzeug 10 soweit in die Bohrung eingeführt, bis der Sitz des Werkzeugs 10 an der zu bearbeitenden Schulter der Bohrung anliegt. Nun wird das Werkzeug 10 mehrmals gedreht und anschließend wieder aus der Bohrung herausgezogen.

Das oben beschriebene Werkzeug mit mehreren Stufen wird insbesondere verwendet bei Unrundheiten der Bohrung oder bei zu großer Rauigkeit der Oberfläche der Bohrung des Bauteiles. Die unterschiedlichen Stufen müssen dann je nach Länge der zu bearbeitenden Bohrung zum Durchmesser der Bohrung ausgelegt sein.

## Patentansprüche

1. Werkstoff für ein Werkzeug zur Behandlung von Oberflächen, wobei auf einem Trägerwerkstoff (50), der aus einer Metallegierung mit einem homogenen, feinkörnigen Gefüge besteht und der ein warmgezogener Hochleistungs-Schnellschnitt-Stahl (HSS) ist, eine nichtmetallische Hartschicht (51) aufgebracht ist.

2. Werkstoff nach Anspruch 1, dadurch gekennzeichnet, daß der Hochleistungs-Schnellschnitt-Stahl eine Mindesthärte von 68 bis 70 HRC (Rockwell) über den gesamten Durchmesser hat.

3. Werkzeug zur Behandlung von Oberflächen von Bauteilen, wobei das Werkzeug aus einem Werkstoff nach Anspruch 1 oder 2 besteht, wobei auf dem Trägerwerkstoff (50) sich eine elektrolytisch-chemisch aufgebrachte Aktivierungsschicht (52) befindet, die eine kohäsive Verbindung mit dem Trägerwerkstoff (50) und der nachfolgenden, anliegenden Reinmetallschicht (53) aufweist, wobei eine durch Eindiffusion von Kohlenstoff und/oder Stickstoff und/oder Sauerstoff mit gleichzeitig zugeführtem weiteren Reinmetall entstandene Übergangsschicht (54) vorhanden ist, deren Anteil an zugeführten Komponenten radial nach außen gesehen immer größer ist und wobei eine nichtmetallische Hartschicht (51) vorhanden ist.

4. Werkzeug zur Behandlung von Oberflächen von Bauteilen, wobei auf einem Trägerwerkstoff (50), der aus einer Metallegierung mit einem homogenen feinkörnigen Gefüge besteht und der ein Hochdrucksinterwerkstoff ist, sich eine elektrolytisch-chemisch aufgebrachte Aktivierungsschicht (52) befindet, die eine kohäsive Verbindung mit dem Trägerwerkstoff (50) und der nachfolgenden, anliegenden Reinmetallschicht (53) aufweist, wobei eine durch Eindiffusion von Kohlenstoff und/oder Stickstoff und/oder Sauerstoff mit gleichzeitig zugeführtem weiteren Reinmetall entstandene Übergangsschicht (54) vorhanden ist, deren Anteil an zugeführten Komponenten radial nach außen gesehen immer größer ist und wobei eine nichtmetallische Hartschicht (51) vorhanden ist.

5. Werkzeug nach Anspruch 3 oder 4, dadurch gekennzeichnet, daß die nichtmetallische Hartschicht (51) wenigstens an der Oberfläche eine Dichtheit von 92 bis 98% aufweist und eine Härte von mindestens 300% der zu behandelnden Oberfläche der Bauteile hat.

6. Verfahren zur Herstellung eines Werkzeugs zur Behandlung von Oberflächen von Bauteilen, wobei bei einem Werkstoff nach Anspruch 1 oder 2 auf dem Trägerwerkstoff (50) elektrolytisch-chemisch eine Aktivierungsschicht (52) aufgebracht wird, die eine kohäsive Verbindung mit dem Trägerwerkstoff (50) und der sich anliegenden Reinmetallschicht (53) bildet, wobei durch Eindiffusion von Kohlenstoff und/oder Stickstoff und/oder Sauerstoff mit gleichzeitig zugeführtem weiteren Reinmetall eine Übergangsschicht (54) gebildet wird, wobei der Anteil an zugeführten Komponenten nach außen gesehen immer größer wird und wobei eine nichtmetallische Hartschicht (51) entsteht.

7. Verfahren zur Herstellung eines Werkzeugs zur Behandlung von Oberflächen von Bauteilen, wobei auf einem Trägerwerkstoff (50), der aus einer Metallegierung mit einem homogenen, feinkörnigen Gefüge besteht und der ein Hochdrucksinterwerkstoff ist, elektrolytisch-chemisch eine Aktivierungsschicht (52) aufgebracht wird, die eine kohäsive Verbindung mit dem Trägerwerkstoff (50) und der sich anliegenden Reinmetallschicht (53) bildet, wobei durch Eindiffusion von Kohlenstoff und/oder Stickstoff und/oder Sauerstoff mit gleichzeitig zugeführtem weiteren Reinmetall eine Übergangsschicht (54) gebildet wird, wobei der Anteil an zugeführten Komponenten nach außen gesehen immer größer wird und wobei eine nichtmetallische Hartschicht (51) entsteht.

8. Verfahren nach Anspruch 6 oder 7, dadurch gekennzeichnet, daß die Eindiffusion von Kohlenstoff und/oder Stickstoff und/oder Sauerstoff und dem Reinmetall mit Hilfe des PVD-Verfahrens (Physical-Vapour-Deposition) durchgeführt wird.

## Claims

1. Material for a tool for the treatment of surfaces, a non-metallic hard layer (51) being deposited on a carrier material (50) which consists of a metal alloy having a homogeneous fine-grained structure and which is a hot-drawn heavy-duty high-speed steel (HSS).

2. Material according to Claim 1, characterized in that the heavy-duty high-speed steel has a minimum hardness of 68 to 70 HRC (Rockwell) over the entire diameter.

3. Tool for the treatment of surfaces of components, the tool consisting of a material according to Claim 1 or 2, the carrier material (50) having on it an electrochemically deposited activating layer (52) which has a cohesive bond with the carrier material (50) and with the subsequent adjacent pure-metal layer (53), there being a transitional layer (54) which occurs as a result of the diffusion of carbon and/or nitrogen and/or oxygen together with further pure metal supplied simultaneously and in which the proportion of constituents supplied increases radially outwards, and a non-metallic hard layer (51) being present.

4. Tool for the treatment of surfaces of components, a carrier material (50), which consists of a metal alloy having a homogeneous fine-grained structure and which is a high-pressure sintered material, having on it an electrochemically deposited activating layer (52) which has a cohesive bond with the carrier material (50) and with the subsequent adjacent pure-metal layer (53), there being a transitional layer (54) which occurs as a result of the diffusion of carbon and/or nitrogen and/or oxygen together with further pure metal supplied simultaneously and in which the proportion of constituents supplied increases radially outwards, and a non-metallic hard layer (51) being present.

5. Tool according to Claim 3 or 4, characterized in that the non-metallic hard layer (51) has, at least on the surface, a density of 92 to 98% and has a hardness of at least 300% of the surface of the components which is to be treated.

6. Method for producing a tool for the treatment of surfaces of components, in the case of a material according to Claim 1 or 2 the carrier material (50) having deposited on it electrochemically an activating layer (52) which forms a cohesive bond with the carrier material (50) and with the adjacent pure-metal layer (53), a transitional layer (54) being formed as a result of the diffusion of carbon and/or nitrogen and/or oxygen together with further pure metal supplied simultaneously, the proportion of constituents supplied increasing outwards, and a non-metallic hard layer (51) being obtained.

7. Method for producing a tool for the treatment of surfaces of components, a carrier material (50), which consists of a metal alloy having a homogeneous fine-grained structure and which is a high-pressure sintered material, having deposited on it electrochemically an activating layer (52) which forms a cohesive bond with the carrier material (50) and with the adjacent pure-metal layer (53), a transitional layer (54) being formed as a result of the diffusion of carbon and/or nitrogen and/or oxygen together with further pure metal supplied simultaneously, the proportion of constituents supplied increasing outwards, and a non-metallic hard layer (51) being obtained.

8. Method according to Claim 6 or 7, characterized in that the diffusion of carbon and/or nitrogen and/or oxygen and of the pure metal is carried out by means of the PVD method (Physical Vapour Deposition).

## Revendications

1. Matière pour un outil de traitement de surfaces, dans lequel on met une couche dure non métallique (51) sur une matière de support (50) qui consiste en un alliage métallique ayant une structure homogène, à grains fins et qui est un acier à coupe rapide (HSS) à haut rendement, étiré à chaud.

2. Matière selon la revendication 1,
caractérisée en ce que
l'acier à coupe rapide à haut rendement a une dureté minimale de 68 à 70 HRC (Rockwell) sur tout son diamètre.

3. Outil pour le traitement de surfaces de pièces de construction, qui consiste en une matière selon la revendication 1 ou la revendication 2, dans laquelle se trouve sur la matière de support (50) une couche d'activation (52) mise de façon chimique et électrolytique, couche qui présente une liaison cohésive avec la matière de support (50) et la couche suivante, adjacentes de métal pur (53), alors qu'il y a une couche de transition (54) obtenue par diffusion de carbone et/ou d'azote avec apport en même temps d'un autre métal pur, couche de transition dont la fraction en composants apportés est, vue radialement vers l'extérieur, est de plus en plus grande et dans laquelle il y a une couche dure non métallique (51).

4. Outil pour le traitement de surfaces de pièces de construction, dans lequel, sur une matière de support (50), qui consiste en un alliage métallique ayant une structure homogène à grains fins, et qui est une matière frittée sous haute pression, se trouve une couche d'activation (52), mise de façon chimique et électrolytique, qui présente une liaison cohésive avec la matière de support (50) et la couche métallique pure, suivante, adjacente, alors qu'il y a une couche de transition (54) obtenue par diffusion de carbone et/ou d'azote et/ou d'oxygène avec apport en même temps d'un autre métal pur, couche de transition dont la fraction en composants apportés, vue radialement vers l'extérieur, est de plus en plus grande et dans laquelle il y a une couche dure non métallique (51).

5. Outil selon la revendication 3 ou 4,
caractérisé en ce que
la couche dure non métallique (51) a au moins sur la surface une densité de 92 à 98 % et une dureté d'au moins 300 % à celle de la surface à usiner des pièces de construction.

6. Procédé de fabrication d'un outil pour le traitement de surfaces de pièces de construction, dans lequel dans le cas d'une matière selon la revendication 1 ou 2 on met sur la matière de support (50) de façon chimique et électrolytique une couche d'activation (52), qui forme une liaison cohésive avec la matière de support (50) et la couche adjacente de métal pur (53), en formant par diffusion de carbone et/ou d'azote et/ou d'oxygène une couche de transition (54) avec apport en même temps d'un autre métal pur, couche de transition dont la fraction en composants apportés, vu facilement vers l'extérieur, est de plus en plus grande et dans laquelle il se forme une couche dure non métallique.

7. Procédé de fabrication d'un outil pour le traitement de surfaces de pièces de construction, dans lequel, sur une matière de support (50), qui consiste en un alliage métallique avec une structure homogène à grains fins, et qui est une matière frittée sous haute pression, on met une couche d'activation (52) de façon chimique et électrolytique, qui forme une liaison cohésive avec la matière de support (50) et la couche adjacente de métal pur (53), en formant par diffusion de carbone et/ou d'azote et/ou d'oxygène une couche de transition (54) avec apport en même temps d'un autre métal pur, couche de transition dont la fraction en composants apportés, vue radialement vers l'extérieur, est de plus en plus grande et dans laquelle il se forme une couche dure non métallique (51).

8. Procédé selon la revendication 6 ou la revendication 7,
caractérisé en ce que
la diffusion de carbone et/ou d'azote et/ou d'oxygène et du métal pur est réalisée à l'aide d'un procédé PVD (Dépôt physique de vapeur).
